# EUROPEAN PATENT SPECIFICATION

(11) **EP 0 525 764 B1**
(45) Date of publication and mention of the grant of the patent: **02.11.1995**
(21) Application number: 92113000.1
(22) Date of filing: 30.07.1992
(51) Int. Cl.: H01J 9/02, H01L 21/52, H01L 23/02

(54) **Method of forming a vacuum micro-chamber for encapsulating a microelectronics device**
Verfahren zur Bildung von Vacuummikrokammern zur Einbettung von Vorrichtungen der Mikroelektronik
Procédé pour former des micro-chambres à vide pour l'encapsulation de dispositifs microélectroniques

(30) Priority: 01.08.1991 US 739267
(43) Date of publication of application: 03.02.1993
(73) Proprietor: TEXAS INSTRUMENTS INCORPORATED, Dallas Texas 75265 (US)
(72) Inventor: Boysel, R. Mark, Plano, Texas 75075 (US)
(74) Representative: Schwepfinger, Karl-Heinz, Dipl.-Ing.

(56) References cited:
- EP-A- 0 306 173
- EP-A- 0 350 378
- WO-A-91/03066

## Description

### TECHNICAL FIELD OF THE INVENTION

The present invention relates in general to microelectronics manufacturing techniques, and more particularly to a process of forming a vacuum micro-chamber for encapsulating a microelectronics device in a vacuum processing chamber and the product of the process.

### BACKGROUND OF THE INVENTION

Recently, the advantages of modeling and fabricating microcavity integrated vacuum tubes are receiving increasing attention by designers of electronic systems. Microcavity integrated vacuum tubes are micrometer-sized devices that employ field emission instead of thermionic emission to generate charge carriers. These vacuum tubes operate as do the conventional vacuum tubes, but are fabricated on a silicon wafer in much the same way as are conventional integrated circuits.

Thin-film methods have been designed to create device layers and microlithography has been used to pattern various layers for these purposes. Conventional methods of producing micro-cavity integrated vacuum tubes, however, use a combination of oxides and refractory metals to form the microcavity structures. There are several problems associated with this approach.

First of all, these process techniques generally use some type of wet-etch process to carve or etch out a cavity within a semiconductor substrate. The wet-etch process is messy and, following the etching, a certain amount of residue is likely to remain. Secondly, during the process, oxide fills the cavity over which a high temperature refractory metal is placed. Once the refractory metal is in place, a wet-etch process is necessary to remove the oxide from within the cavity. Removing the oxide necessitates both a wet-etch technique and the use of refractory or high temperature metals. The wet-etch technique is necessary because of the chemical properties of the oxide. The high temperature or refractory metals are necessary to resist the corrosive effects of the wet-etch techniques. The result of this wet-etch technique often is a less than fully evacuated cavity within the substrate, a partly corroded refractory metal, and the potential of wet-etch residue within the cavity. As a result, less than optimal performance of the microcavity integrated vacuum tube can be expected using this technique.

If a process existed that could avoid the use of refractory metals, oxides for the cavity filling material, and the wet-etch techniques, a significantly improved vacuum micro-chamber would result. The benefits of having a clean vacuum chamber for the production of microcavity integrated vacuum tubes and other electronic devices may, then, be seen in many applications. These applications may include nuclear reactor instrumentation, fusion reactor instrumentation, accelerator instrumentation, bore hole seismic profiling, and space power systems. Additionally, high speed sensors, communication systems, and data processing systems would likely benefit from the high speed that vacuum chamber devices such as vacuum triodes or diodes on an integrated semiconductor substrate could achieve. Consequently, there are both the need for improved processing techniques and a variety of applications for these vacuum microelectronics devices.

In essence, there is a need for a method of producing a vacuum micro-chamber for encapsulating a microelectronics device that avoids the use of oxide as the micro-chamber spacer material.

There is the reed for a method of producing a vacuum micro-chamber device that permits the use of lower temperature metals and, thereby, takes advantage of their manufacturing properties.

There is a further need for a method of producing a vacuum micro-chamber for encapsulating a microelectronics device that fully avoids the use of wet-etch techniques that leave residues and may not fully evacuate the vacuum micro-chamber of the chamber spacer material.

### SUMMARY OF THE INVENTION

Accordingly, the present invention provides a method of forming a vacuum micro-chamber that overcomes the limitations and satisfies the needs previously identified.

The present invention is defined by the method of claim 1, the device of claim 2 and the compositions of claims 3 and 6. Embodiments of the invention are set out in the dependent claims.

According to one aspect of the invention, there is provided a method of forming a vacuum micro-chamber for encapsulating a microelectronics device. Within a vacuum semiconductor device fabrication reactor, the method comprises the steps of first forming or placing the microelectronics device on a substrate base. Next, an organic spacer such as photoresist covers the microelectronics device. Then, a metal layer forms over the organic spacer and seals around the organic spacer at the substrate base so that the metal layer covers all of the organic spacer except a predetermined number of access apertures to the organic spacer. The method then requires the removal of the organic spacer through the access apertures to form a vacuum chamber for the microelectronics device. As a result, the chamber interior has on one side the substrate base and the microelectronics device and on the other side the metal layer. The next step of the process is to seal the vacuum chamber by closing off the access apertures. Once the vacuum microelectronics device leaves the fabrication reactor, the seal causes the chamber to maintain the reactor vacuum.

As a result of the above method, a unique intermediate product of the present invention arises. The product comprises the substrate base which may include a silicon material and perhaps an insulating dielectric on which the microelectronics device appears. Over the microelectronics device is the organic spacer or photoresist and over the photoresist is the metal layer. The metal layer fully covers the photoresist and makes a seal around the photoresist except for the access apertures. At this point, an isotropic plasma etching process may be used to evacuate the chamber and a sealing metal may be placed over the metal layer to close off the access aperture and maintain the seal between the substrate base-microelectronics device portion and the metal layer portion.

A technical advantage of the present invention is that it requires no etching into the substrate base and thereby avoids this use of a wet-etch technique.

Another technical advantage of the present invention is that it uses a photoresist or organic spacer to create the volume for the vacuum chamber. This avoids first the wet-etch necessary to create the cavity within the semiconductor substrate and secondly avoids the need to use the wet-etch technique to remove the oxide that appears in conventional methods of forming the vacuum chamber. The isotropic plasma etching techniques do not leave a residue as do the anisotropic wet-etch techniques. The result is a much cleaner device than is possible with no microcavity formation methods.

Yet another technical advantage of the present invention is that because the method avoids wet-etch techniques, it is not necessary to use the high temperature or refractory metals of known techniques. This adds a significant degree of freedom in the microelectronics device fabrication.

### BRIEF DESCRIPTION OF THE DRAWINGS

The present invention, as well as its modes of use and preferred embodiment will best be understood with reference to the following detailed description of the preferred embodiment when taken in conjunction with the accompanying FIGUREs, wherein:
FIGURE 1 is a top-down schematic view of a preferred embodiment of the micro-chamber according to the method of the present invention;
FIGUREs 2a and 2b are side cross-sectional views of the device of FIGURE 1 taken at the respective 2a and 2b slices shown of FIGURE 1;
FIGUREs 3a and 3b show the respective 2a and 2b cross-sectional views with sealing metal layers;
FIGURE 4 illustrates a vacuum micro-chamber device formed according to a preferred embodiment of the method of the present invention; and
FIGUREs 5a and 5b illustrate side cross-sectional views of the device of FIGURE 4 according to the respective 5a and 5b cross-sections indicated in FIGURE 4.

### DETAILED DESCRIPTION OF THE INVENTION

The preferred embodiment of the present invention is described below with reference to the accompanying FIGUREs, like numerals being used for like and corresponding parts of the various drawings.

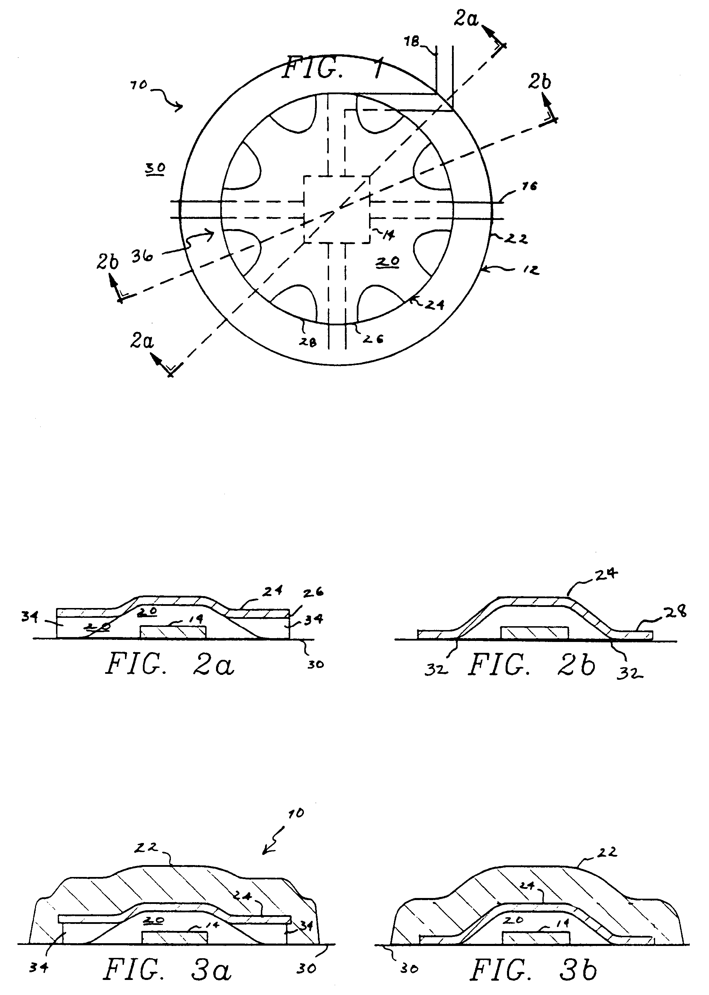

FIGURE 1 shows the vacuum microelectronics device 10 of the process of the preferred embodiment of the present invention. According to FIGURE 1, the vacuum device 10 and process of the preferred embodiment result in a vacuum chamber 12 covering microelectronics device 14. Microelectronics device 14 may attach to leads 16 and 18 according to its particular application. Vacuum micro-chamber 12 comprises space 20 which is sealed by sealing metal layer 22 and support metal layer 24. Support metal layer 24 has alternating raised portions 26 and lowered portions 28. Lowered portions 28 contact semiconductor substrate base 30. As a result, vacuum micro-chamber 12 establishes a vacuum within which microelectronics device 14 may operate as a vacuum triode or diode or other microelectronics device that advantageously uses a vacuum environment.

To better understand the configuration of FIGURE 1, FIGUREs 2a and 2b provide a cross-sectional view at the cross-section lines or slices 2a and 2b that appear in FIGURE 1. According to FIGURE 2a, on substrate 30 appears vacuum microelectronics device 10 which includes metal layer 24 over vacuum chamber space 20. Vacuum chamber space 20 separates metal layer 24 from microelectronics device 14. FIGURE 2b shows the 2b cross-section of FIGURE 1. Of note in FIGURE 2b is the contact that metal layer 24 makes at points 32 to semiconductor substrate 30 to seal vacuum chamber space 20.

FIGUREs 3a and 3b show the complete cross-section of FIGURE 1 at respective slices 2a and 2b. And further include sealing metal 22 which closes off access apertures 34 of vacuum seal 20 to maintain a vacuum therewithin.

An important aspect of the present invention is the manner of making vacuum microelectronics device 10. With reference to FIGUREs 1, 2a and 2b, and 3a and 3b, the following describes the process for forming the preferred embodiment of microelectronics device 10.

To begin the process, microelectronics device 14 together with leads 16 and 18 with appropriate electrical insulting dielectric may be formed on semiconductor substrate 30. The next step is to form a layer of organic spacer over microelectronics device 14 and leads 16 and 18. For the preferred embodiment, the organic spacer takes the star shaped form 36 in FIGURE 1 that raised portions 26 and lowered portions 28 of metal layer 24 outline. Next, metal layer 24 is deposited over the organic spacer and contacts the region outside device 14 and the organic spacer. In FIGURE 1 where the organic spacer had the protruding portions of the star shaped figure 36 the portions of the metal layer 24 that contact semiconductor substrate 30 are those arched in segments such as 28. Those portions of metal layer 24 that cover the protruding portions of star shaped figure 36 will form raised portions 26 and do not seal the photoresist at this stage in the process. The result is the configuration that FIGUREs 2a and 2b illustrate.

FIGURE 2a shows that the raised portions of metal layer 26 provide an access aperture 34 into vacuum chamber space 20. On the other hand, FIGURE 2b shows that lowered portions 28 seal off vacuum chamber space 20. The next step in the process is to remove the photoresist from beneath metal layer 24. This may be done using an isotropic plasma etch as is done in the preferred embodiment. The result of this step is that metal layer 24 serves as a metal shell with access apertures 34 near the edges. Metal layer 24 is supported by the contact that it makes at lowered portions 28. The next step is to evacuate vacuum chamber 20. This occurs during the a metal deposition step which forms sealing metal 22 over metal layer 24 to close access apertures 34 as FIGURE 3a and 3b illustrate.

The method of the present invention uses a method typical in deformable mirror device processing by including an organic spacer and an isotropic plasma etch for spacer removal. Since a low temperature plasma etch may be used for organic spacer removal in the preferred embodiment, the metal seal 22, as well as the metal layer 24, may function as the upper electrode of microelectronics device 14 to form a micro-triode or micro-diode, for example.

Particular advantages of the present invention are that using the isotropic etch, which is a dry process, permits a smaller access holes 34 which are easier to seal. Moreover, the dry isotropic plasma etch is a clean process that does not have the residue problems associated with wet-etch techniques. Furthermore, the method of the present invention is a low temperature process that is compatible with many process technologies. The processes with which the present invention may be compatible are gallium arsenide and metal oxide semiconductor processes.

The present invention may be used for a variety of products having a variety of applications. See for example the process described in EP-A-0 525 763. Additionally, the present invention may be used to form a micro-mass spectrometer, micro-light bulbs, or micro-thermocouple gages.

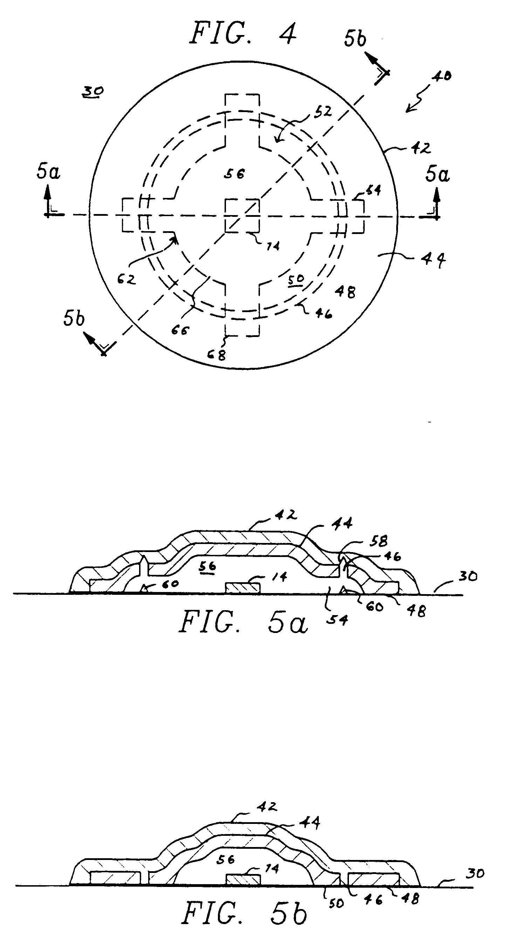

To more fully understand the present invention an alternative embodiment is provided in FIGUREs 4, 5a and 5b. According to FIGURE 4, there is shown on semiconductor substrate 30 microelectronics device 14 at the center of vacuum microelectronics device 40. The alternative embodiment device 40 comprises sealing metal layer 42 over metal layer 44 having access ring 46 to separate outer portion 48 from inner portion 50. Metal layer 44 covers vacuum chamber 52 having protrusions 54 and center volume 56. FIGUREs 5a and 5b show respective cross-sectional slices 5a and 5b of FIGURE 4. In FIGURE 5a sealing metal 42 covers metal layer 44 which surrounds vacuum chamber 52 including central portion 56 and protruding portion 54. Of particular interest in FIGURE 5a is the cross-sectional view of access apertures 46 which may be either a complete circle surrounding inner portion 50 of metal layer 44 or may simply be a plurality of holes of a small diameter such as to the width that FIGURE 5a shows. FIGURE 5a also shows raised portion 58 of metal seal 42 which is formed when deposit 60 falls through access aperture 46 onto semiconductor substrate 30.

FIGURE 5b shows the 5b slice or cross-section in FIGURE 4. Since this cross-section does not include vacuum chamber 52 protrusions 54, metal layer 44 only covers central vacuum chamber portion 56. In the cross-section of FIGURE 5b, both inner portion 50 and outer portion 48 of metal layer 44 contact semiconductor substrate 30. Consistently, access aperture 46 is not empty as in the FIGURE 5a cross-section, but is filled with sealing metal layer 42.

The procedure for forming alternative embodiment 4a is similar to that of the preferred embodiment of FIGURE 1. In essence, once microelectronics device 14 is ready for assembly into alternative embodiment vacuum microelectronics device 40, it is placed on semiconductor substrate 30. Thereafter, a layer of photoresist or other suitable organic spacer is formed in the cruciform pattern 62 having circular center 66. Then, metal layer 44 is deposited over photoresist pattern 62, but this time includes access apertures 46 which may either be a plurality of small access holes or a continuous ring that separates outer portion of metal layer 48 from inner portion 50. As FIGURE 5a shows, a portion of access apertures 46 cover protrusions 68 of the photoresist cruciform pattern 62. The remainder of metal layer 44 seals around the circular center of pattern 62 to make a vacuum tight seal. The next step is to remove through access apertures 46 photoresist to form vacuum chamber 52 which, in the pattern of cruciform 62, contains center vacuum portion 56 and protrusions 54. Next, vacuum chamber 52 is evacuated and sealed within the vacuum of the fabrication reactor environment with sealing metal 42 to create a completely sealed vacuum chamber 52.

Noteworthy in alternative embodiment 40 of the present invention is that by virtue of a phenomenon characteristic of depositing a continuous metal layer over a plurality of access apertures such as 46. In this instance, a portion of metal layer 44 falls through access apertures 46 to deposit on semiconductor substrate 30 as points 60. As long as points 60, which contain conductive metal from sealing metal 42, do not contact either microelectronics device 14 or metal layer 44 this should not cause any problems in the design of vacuum microelectronics device 40.

The alternative embodiment 40 of FIGURE 4 also includes the advantages and benefits of the preferred embodiment of FIGURE 1.

## Claims

1. A method of forming a vacuum micro-chamber (12) for encapsulating a microelectronics device (14) on a substrate base (30) in a vacuum fabrication reactor, comprising the steps of:
covering the microelectronics device with an organic spacer (36);
covering said organic spacer and the substrate base with a metal layer (24) so that said metal layer covers all of said organic spacer except a predetermined number of access apertures (34) to said organic spacer;
removing said organic spacer through said access apertures to form a vacuum chamber (12) between said substrate base and said metal layer; and
sealing said vacuum chamber by closing off said access apertures.

2. A vacuum microelectronics device (10) on a substrate material (30) for a microelectronics device (14) associated with the substrate material comprising:
a metal layer (24) associated with the substrate material (30) and covering the microelectronics device, said metal layer having a plurality of sealed access apertures;
a vacuum chamber (12) separating the microelectronics device from said metal layer, said vacuum chamber comprising said metal layer and the semiconductor substrate and formable by removing from between the semiconductor substrate and said metal layer an organic spacer (36); and
a metal seal (22) for sealing said access apertures of said metal layer thereby maintaining said vacuum within said vacuum chamber.

3. A composition for producing a vacuum microelectronics device (10), comprising:
a substrate base (30);
a microelectronics device (14) associated with said substrate base;
an organic spacer (36) covering said microelectronics device and a portion of said substrate base; and
a metal layer (24) covering said organic spacer and the substrate base, said metal layer comprising a plurality of apertures (34) for exposing a predetermined portion of said organic spacer.

4. The composition of Claim 3, wherein said organic spacer may be removed by an isotropic plasma etch in a vacuum processing chamber.

5. The composition of Claim 4, wherein said composition further comprises of metal seal covering said metal layer and sealing said apertures following the removal of said organic spacer in an isotropic plasma etch process.

6. A composition for producing a vacuum micro-chamber (52) to encapsulate a microelectronics device (40) in a vacuum processing chamber comprising:
a substrate material (30);
a microelectronics device (40) associated with said substrate material (30);
a layer of organic spacer (62) over said microelectronics device, said organic spacer having a center portion (66) and a plurality of protrusions (68) of said organic spacer from said center portion; and
a layer (44) covering said organic spacer and the substrate base and providing a plurality of access apertures (46) to expose said protrusions of said organic spacer.

7. The composition of Claim 6, wherein said covering layer comprises a transparent dielectric for providing optical access to the vacuum micro-chamber.

## Patentansprüche

1. Verfahren zur Bildung einer Vakuummikrokammer (12) zum Einbetten eines Mikroelektronik-Bauelements (14) auf einem Substratsockel (30) in einem Vakuumherstellungsreaktor, enthaltend die Schritte:
Bedecken des Mikroelektronik-Bauelements mit einem organischen Abstandshalter (36);
Bedecken des organischen Abstandshalters und des Substratsockels mit einer Metallschicht (24), so daß die Metallschicht den gesamten organischen Abstandshalter mit Ausnahme einer vorbestimmten Anzahl von Zugangsöffnungen (34) zu dem organischen Abstandshalter bedeckt;
Entfernen des organischen Abstandshalters durch die Zugangsöffnungen zur Bildung einer Vakuumkammer (12) zwischen dem Substratsockel und der Metallschicht; und
Abdichten der Vakuumkammer durch Verschließen der Zugangsöffnungen.

2. Mikroelektronisches Vakuumbauelement (10) auf einem Substratmaterial (30) für ein Mikroelektronik-Bauelement (14), das dem Substratmaterial zugeordnet ist, enthaltend:
eine dem Substratmaterial (30) zugeordnete und das Mikroelektronik-Bauelement bedeckende Metallschicht (24), wobei die Metallschicht mehrere abgedichtete Zugangsöffnungen aufweist;
eine das Mikroelektronik-Bauelement von der Metallschicht trennende Vakuumkammer (12), wobei die Vakuumkammer die Metallschicht und das Halbleitersubstrat umfaßt und durch Entfernen eines anorganischen Abstandshalters (36) aus dem Bereich zwischen dem Halbleitersubstrat und der Metallschicht herstellbar ist; und
eine Metalldichtung (22) zum Abdichten der Zugangsöffnungen der Metallschicht, wodurch innerhalb der Vakuumkammer das Vakuum aufrechterhalten wird.

3. Zusammensetzung zur Erzeugung eines Vakuum-Mikroelektronikbauelements (10), enthaltend:
einen Substratsockel (30);
ein Mikroelektronik-Bauelement (14), das dem Substratsockel zugeordnet ist;
einen organischen Abstandshalter (36), der das Mikroelektronik-Bauelement und einen Teil des Substratsockels bedeckt; und
eine Metallschicht (24), die den organischen Abstandshalter und den Substratsockel bedeckt, wobei die Metallschicht mehrere Öffnungen (34) zum Freilegen eines vorbestimmten Abschnitts des organischen Abstandshalters aufweist.

4. Zusammensetzung nach Anspruch 3, bei welcher der organische Abstandshalter durch ein isotropes Plasmaätzen in eine Vakuumverarbeitungskammer entfernt werden kann.

5. Zusammensetzung nach Anspruch 4, bei welcher die Zusammensetzung ferner eine Metalldichtung aufweist, die die Metallschicht bedeckt und die Öffnungen im Anschluß an das Entfernen des organischen Abstandshalters in einem isotropen Plasmaätzprozeß abdichtet.

6. Zusammensetzung zum Erzeugen einer Vakuummikrokammer (52) zum Einbetten eines Mikroelektronik-Bauelements (40) in einer Vakuumverarbeitungskammer, enthaltend:
ein Substratmaterial (30);
ein dem Substratmaterial (30) zugeordnetes MikroelektronikBauelement (40);
eine Schicht eines organischen Abstandshalters (62) über dem Mikroelektronik-Bauelement, wobei der organische Abstandshalter einen Mittelabschnitt (66) und mehrere Vorsprünge (68) des organischen Abstandshalters an dem Mittelabschnitt enthält; und
eine Schicht (44), die den organischen Abstandshalter und den Substratsockel bedeckt und mehrere Zugangsöffnungen (46) zum Freilegen der Vorsprünge des organischen Abstandshalters bildet.

7. Zusammensetzung nach Anspruch 6, bei welcher die Abdeckschicht ein transparentes Dielektrikum zur Erzielung eines optischen Zugangs zu der Vakuummikrokammer umfaßt.

## Revendications

1. Procédé de formation d'une micro-chambre (12) à vide pour l'encapsulage d'un dispositif (14) microélectronique sur une base (30) de substrat dans un réacteur de fabrication à vide, comprenant les étapes de :
couvrir le dispositif micro-électronique avec une pièce d'écartement (36) organique;
couvrir ladite pièce d'écartement organique et la base de substrat avec une couche (24) de métal de telle sorte que ladite couche de métal couvre l'ensemble de ladite pièce d'écartement organique à l'exception d'un nombre prédéterminé d'ouvertures d'accès (34) vers ladite pièce d'écartement organique;
retirer ladite pièce d'écartement organique à travers lesdites ouvertures d'accès pour former une chambre (12) à vide entre ladite base de substrat et ladite couche de métal; et
sceller ladite chambre à vide en fermant lesdites ouvertures d'accès.

2. Dispositif (10) micro-électronique à vide sur un matériau (30) de substrat pour un dispositif (14) micro-électronique associé au matériau de substrat comprenant :
une couche (24) de métal associée au matériau (30) de substrat et couvrant le dispositif micro-électronique, ladite couche de métal ayant une pluralité d'ouvertures d'accès scellées;
une chambre (12) à vide séparant le dispositif micro-électronique de ladite couche de métal, ladite chambre à vide comprenant ladite couche de métal et le substrat semi-conducteur et peut être formé par retrait d'entre le substrat semi-conducteur et ladite couche de métal d'une pièce d'écartement (36) organique ; et
un scellement (22) de métal pour sceller lesdites ouvertures d'accès de ladite couche de métal maintenant ainsi ledit vide à l'intérieur de ladite chambre à vide.

3. Composition pour la production d'un dispositif (10) micro-électronique à vide comprenant :
une base (30) de substrat;
un dispositif (14) micro-électronique associé à ladite base de substrat ;
une pièce d'écartement (36) organique couvrant ledit dispositif micro-électronique et une portion de ladite base de substrat ; et
une couche (24) de métal couvrant ladite pièce d'écartement organique et la base de substrat, ladite couche de métal comprenant une pluralité d'ouvertures (34) pour exposer une portion prédéterminée de ladite pièce d'écartement organique.

4. Composition selon la revendication 3, dans laquelle ladite pièce d'écartement organique peut être retirée par une attaque de plasma isotrope dans une chambre de traitement à vide.

5. Composition selon la revendication 4, dans laquelle ladite composition comprend en outre un scellement de métal couvrant ladite couche de métal et scellant lesdites ouvertures suivant le retrait de ladite pièce d'écartement organique dans un procédé d'attaque de plasma isotrope.

6. Composition pour produire une micro-chambre (52) à vide pour encapsuler un dispositif (40) microélectronique dans une chambre de traitement à vide comprenant :
un matériau (30) de substrat;
un dispositif (40) micro-électronique associé audit matériau (30) de substrat;
une couche de pièce d'écartement (62) organique sur ledit dispositif micro-électronique, ladite pièce d'écartement organique ayant une portion (66) de centre et une pluralité de saillies (68) de ladite pièce d'écartement organique depuis ladite portion de centre ; et
une couche (44) couvrant ladite pièce d'écartement organique et la base de substrat et fournissant une pluralité d'ouvertures (46) d'accès pour exposer lesdites saillies de ladite pièce d'écartement organique.

7. Composition selon la revendication 6, dans laquelle ladite couche de recouvrement comprend un diélectrique transparent pour fournir un accès optique à la micro-chambre à vide.
